# EUROPEAN PATENT APPLICATION

(11) **EP 3 396 719 A1**
(43) Date of publication of application: **31.10.2018**
(21) Application number: 17305473.5
(22) Date of filing: 27.04.2017
(51) Int. Cl.: H01L 31/0224, H01L 31/18, H01L 29/41

(54) **COPPER NANOWIRE HYBRID COATING**

(71) Applicant: Université de Strasbourg, 67000 Strasbourg (FR); CENTRE NATIONAL DE LA RECHERCHE SCIENTIFIQUE, 75016 Paris (FR)
(72) Inventor: ALIPRANDI, Alessandro, 67000 STRASBOURG (IT); ANICHINI, Cosimo, 67000 STRASBOURG (FR); BONACCHI, Sara, 67000 STRASBOURG (FR); SAMORI, Paolo, 67000 STRASBOURG (FR)
(74) Representative: Lavoix

(57) **Abstract**

The present invention concerns a process for preparing a material comprising a substrate and a coating layer comprising copper nanowires and reduced graphene oxide, said process comprising:
- placing at least one copper nanowires layer on a substrate, placing at least one graphene oxide layer in contact with a copper nanowire layer;
- simultaneously chemically reducing graphene oxide (GO) and copper nanowires (Cu NWs), thereby forming onto the substrate a coating layer comprising copper nanowires and reduced graphene oxide (rGO), thereby
- providing a material comprising a substrate and a coating layer comprising copper nanowires and reduced graphene oxide.

The present invention also concerns substrate material comprising a substrate comprising or consisting of a material having a glass transition temperature lower than 180°C; and a layer comprising copper nanowires and reduced graphene oxide, said layer coating at least one surface of said substrate.

## Description

The present invention concerns a process for preparing a coating layer comprising copper nanowires and reduced graphene oxide.

The present invention also concerns a substrate comprising a layer comprising copper nanowires and reduced graphene oxide.

### Technological background

Transparent conducting films are key component in modern electronics and widespread employed for the fabrication of touch screens, flat displays, solar cells and organic light-emitting diodes. Indium tin oxide (ITO) is currently the most widely used transparent conducting film because of its high transparency and high conductivity as well as for its electrochemical stability. However, ITO films are mechanically fragile and expensive due to the high preparation cost and the scarcity of indium in the earth's crust. Therefore, the development of new, low-cost, stable and large-scalable transparent electrodes is one of the major challenges in this field. Recently, metallic nanowires (NWs) based on copper or silver have attracted considerable attention being characterized by a conductivity and a transmittance that are comparable with those of ITO. Moreover, NWs can be readily dispersed into solution and deposited onto different substrates by spray coating or using a meyer rod, which represent big advantages for industrial production. Among them, copper represents the cheapest alternative since its cost is almost 3 order of magnitude lower than other metals. Recently, a green large scale hydrothermal synthesis of high-quality copper nanowires (Cu NWs) has been reported with tunable aspect ratios using non-toxic amino acids, hydrophobic amines and glucose as reducing agent.

Despite the increasing interest in these kinds of nanomaterials for electronic devices, several fundamental problems still remains unsolved. In particular, the application of Cu NWs in working device is hindered by their chemical instability due to their propensity to undergo oxidation which results in a complete loss of their conductive property. To remove the so-formed oxide layer, usually a post deposition treatment based on high temperature (> 175 °C) annealing in reducing hydrogen atmosphere is required. More recently, annealing-free processes have been reported which consist in acid etching and photonic sintering. In parallel, many efforts have been done to protect Cu NWs from oxidation including nickel alloying and the use of inorganic shells. However, this latter approach, requires further steps such as atomic layer deposition (ALD) or the electrodeposition of a metal (Zn, Sn, or In) onto the surface of Cu NWs network, followed by oxidation to create a transparent oxide shell. Moreover, even if the protection of Cu NWs through inorganic (semiconducting or insulating) oxide shell can lead high stability of the Cu NWs, such surface passivation can negatively affect or even completely block the heterogeneous electron transfer making them no longer suitable as electrodes in electrochemical devices.

Graphene has been recently reported as long term oxidation barrier against oxidation. However the cost of the production of high quality chemical vapor deposition (CVD) graphene sheets and the tedious and expansive transfer process makes such approach not suitable for low cost electrodes. On the contrary, graphene oxide (GO) has received large attention in the past decade thanks to its low production cost and its high solubility in polar solvents. Moreover, even if GO is almost an insulator the graphitic structure and then its conductivity can be restored to a large extent by thermal or chemical processes. Taking inspiration from these materials, Ruoff et al. (I. N. Kholmanov, S. H. Domingues, H. Chou, X. Wang, C. Tan, J.-Y. Kim, H. Li, R. Piner, A. J. G. Zarbin and R. S. Ruoff, *ACS Nano,* 2013, 7, 1811-1816) have recently reported that Cu NWs covered by reduced GO (rGO) films act as transparent electrodes in electrochromic devices due to a good oxidation resistance, substrate adhesion and stability. However, they need to use several-steps approach for preparing these kind of Cu NWs/rGO based electrodes such as annealing steps for avoiding cupper oxidation and poly(methyl methacrylate) (PMMA) dry transfer for mechanically imposed rGO films on top of Cu NWs, which severely limit the large scale production and increase the preparation cost.

The application of copper nanowires in working devices is hindered by their chemical instability due to their propensity to undergo oxidation which results in a complete loss of their conductive property. To remove the so-formed oxide layer, usually a post-deposition treatment based on high temperature (>175°C) annealing in reducing hydrogen atmosphere is required.

### Aims of the invention

Present inventors' efforts toward the development of effective, transparent and highly conductive electrodes were focused on the optimization of a green and low-cost preparation approach of Cu NWs/rGO films potentially suitable for any kind of substrates and applicable as transparent electrodes in different type of electronic devices.

The present invention aims to provide a solution to the technical problem of replacing ITO as conductive electrodes for electronic applications.

The present invention aims to provide a solution to the technical problem of providing a highly conductive, transparent and robust electrode or film for an electrode made of Cu.

Accordingly, the present invention aims to provide a solution to the technical problem of providing Cu NWs/rGO films and their preparation process potentially suitable for any kind of substrates, and particularly suitable for substrates having a glass temperature below 180°C.

The present invention aims to provide a solution to the technical problem of providing Cu NWs/rGO films applicable as transparent electrodes, notably for use in an electronic devices. "rGO" stands for reduced graphene oxide.

The present invention aims to provide a solution to the technical problem of providing a green and low-cost process for preparing Cu NWs/rGO films.

### Detailed description of the invention

The inventors have found a solution to the above described technical problems.

The inventors have discovered a process for preparing Cu NWs/rGO films solving the above described technical problems.

The present invention relates to a process for preparing a material comprising a substrate and a coating layer comprising copper nanowires and reduced graphene oxide, said process comprising:
- placing at least one copper nanowires layer on a substrate, placing at least one graphene oxide layer in contact with a copper nanowire layer;
- simultaneously reducing graphene oxide (GO) and copper nanowires (Cu NWs), thereby forming onto the substrate a coating layer comprising copper nanowires and reduced graphene oxide (rGO), thereby
- providing a material comprising a substrate and a coating layer comprising copper nanowires and reduced graphene oxide.

The present invention relates to a material comprising a substrate comprising or consisting of a material having a glass transition temperature lower than 180°C; and a layer comprising copper nanowires and reduced graphene oxide, said layer coating at least one surface of said substrate.

The present invention relates to a material obtained according to a process as defined in the present invention.

The present invention relates to transparent electrodes comprising a material as defined in the present invention.

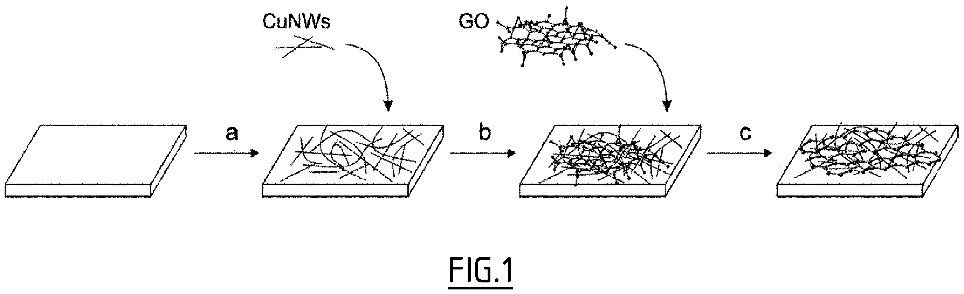

In particular, the inventors optimized a straightforward preparation method based on three-steps strategy. A process is illustrated by Figure 1.

In one embodiment, said process comprises the deposition of a suspension of Cu NWs on said substrate.

Advantageously, said process comprises a spray deposition of a suspension of GO, preferably GO flakes, on said Cu NWs.

In one embodiment, said suspension is an ethanolic suspension.

Advantageously, said process comprises simultaneously chemically reducing Cu NWs and GO in the presence of NaBH₄ as reducing agent.

Advantageously, the simultaneous chemical reduction is performed in water.

In one embodiment, the simultaneous chemical reduction is performed at a temperature ranging from 15 to 30°C, preferably at room temperature (20-25°C).

More specifically, a preferred process of the present invention comprises:
i) spray deposition of an ethanolic suspension of Cu NWs, followed by
ii) spray deposition of an ethanolic suspension of GO flakes and finally,
iii) a simultaneous chemical reduction of the so-obtained two components film in water at room temperature in the presence of NaBH₄ as reducing agent.

In one embodiment, said reduction step is performed in the presence of a mild reducing agent.

Preferably, said reduction step is performed in water.

Preferably, said reduction step is performed at room temperature, i.e. without voluntary heating or cooling.

Advantageously, a process according to the present invention avoids the use of harmful solvents and reagents.

Advantageously, a process according to the present invention does not comprise a step of annealing the material, especially the Cu NWs/rGO layer.

In one embodiment, Maillard reaction type is used for preparing Cu NWs.

Typically, Cu NWs dispersion was prepared according to published procedure (M. Kevin, G. Y. R. Lim and G. W. Ho, Green Chemistry, 2015, 17, 1120-1126) (with some modifications) and involved a Cu(II) salt, a surfactant, a reducing agent and an additive, using water as solvent.

In one embodiment, said is Cu(II) salt CuCl₂. Other suitable Cu sources are notably CuNO₃ and CuSO₄.

Preferably, octadecylamine is used as surfactant and capping agent.

Preferably, glucose is used as reducing agent for preparing Cu NWs.

In one embodiment, the Cu NWs were dispersed in a polar solvent such as for example EtOH.

Advantageously, a process according to the present invention allows eliminating the need for additional treatments in the electrodes preparation reducing the cost and the timing.

Advantageously, a process according to the present invention allows producing highly stable transparent electrodes suitable for flexible electronics starting from cheap materials and by using a chemical mild approach.

In one embodiment, the present invention relates to a process for preparing copper nanowires/reduced graphene oxide hybrid coating layer onto any inorganic and organic material.

Advantageously, a Cu NWs network is formed. Typically, a thin Cu(II)O passivation layer is formed on the Cu NWs surface prior to reduction step.

Advantageously, SEM image of Cu NWs network is characterized by the presence of long nanowires with an average diameter of 126±33 nm and a length larger than 20 µm.

In one embodiment, graphene oxide (GO) is present in the form of GO flakes.

In one embodiment, GO is present in the form of GO suspension.

In one embodiment, said substrate comprises or consists of a material having a glass transition temperature lower than 180°C.

In one embodiment, said substrate comprises or consists of an inorganic, an organic material, or a combination thereof.

In one embodiment, said substrate is selected from the group consisting of glass, a plastic material, preferably a transparent plastic material, or a combination thereof.

Advantageously, said substrate is a flexible substrate such as for example a flexible polymer film or sheet. Examples of such polymer film or sheet are polyethylene terephthalate (PET) films and a polyethylene (PE) films, such as for example a PE film for food (for example a domopak® PE film, with a 2.5 cm x 2.5 cm lateral size and a thickness of 200 µm)

In one embodiment, said substrate is a metallic coated substrate. For example said substrate is an Au coated substrate, a Cr coated substrate or a Cr and Au coated substrate.

Advantageously, said substrate is treated for improving its affinity with GO.

Advantageously, said substrate is surface treated with a compound having at least one silane functional group and at least one amine group to form an amino silane coated surface. Examples of such compounds include, but are not limited to (aminoalkyl)alkoxysilane, some examples are, without limitation, 4-aminobutyltriethoxysilane, n-(2-aminoethyl)-3-aminopropylmethyldimethoxysilane, n-(2-aminoethyl)-3-aminopropyltriethoxysilane, n-(2-aminoethyl)-3-aminopropyltrimethoxysilane, 3-aminopropyldiisopropylethoxysilane, 3-aminopropylmethylbis(trimethylsiloxy)silane, 3-aminopropyldimethylethoxysilane, 3-aminopropylmethyldiethoxysilane, 3-aminopropyltris(methoxyethoxyethoxy)silane, 3-aminopropyltris(trimethylsiloxy)silane, 3-aminopropyltrimethoxysilane and 3-aminopropyltriethoxysilane.

In one embodiment, the Cu NWs are deposited onto a substrate by using an airbrush.

Interestingly, the use of the airbrush technique allows easily tuning the amount of material (i.e. Cu NWs and GO flakes) deposited onto the substrate, therefore to have a fine control over the transmittance and the conductivity of the films at will.

Advantageously, the present invention allows reducing simultaneously both the bottom Cu NWs network and the upper GO flakes without any corrosion of the Cu Nws, Preferably, Cu Nws are perfectly intact (no detectable corrosion by SEM micrograph of Cu Nws/GO hybrid) after reduction step.

Advantageously, once Cu NWs and GO assembled, the layer was treated by dipping inside an aqueous solution of NaBH₄ at room temperature.

Advantageously, the use of NaBH₄ water solution was the more effective and less invasive.

In one embodiment, the NaBH₄ aqueous solution is a 0.1% w/w, 14 mM NaBH₄ aqueous solution.

Separately formed Cu NWs film and rGO film are not suitable for replacing ITO as conductive electrodes for electronic applications since reduced Cu NWs films are not stable over a long-time when exposed to air condition and rGO films are not enough conductive themselves.

Surprisingly, the preparation of a pre-assemble two-components film in which GO are spray-coated on top of Cu NWs network film solves this technical problem. Accordingly, a layer comprising a Cu NWs network and rGO is particularly advantageous, especially as prepared by the present invention with a simultaneous reduction of Cu NWs and GO.

Preferably, a coating layer according to the present invention is highly conductive, transparent and robust.

Advantageously, the present invention allows increasing the stability and the conductivity of Cu NWs network films.

Advantageously, Cu NWs/rGO layer presents a sheet resistance of 40±**10** ohm/sqr with only 10% loss of transmittance.

In one embodiment, the Cu NWs/rGO layer comprises other components.

In one embodiment, the Cu NWs/rGO layer consists of Cu NWs and rGO.

Advantageously, Cu NWs/rGO layer comprises grain boundaries at the edges of graphene.

Typically, because of the thin thickness of the coating layer (for example 130±10 nm), the coating layer is designated as a film.

In one embodiment, said Cu NWs and GO film has a thickness of 350± 100 nm (as measured by PESA.

Advantageously, the present invention confirms not only the possibility to have a fine control over the formation of Cu NWs and GO films by using a spray-coating approach but also, that it is possible to effectively increase their conductivity by using mild conditions such as a water NaBH₄ solution at room temperature, without dramatically losing their transmittance.

Typically, in Cu NWs/rGO layer according to the invention, Cu(II) peaks at 940-945 eV and 965 eV are no longer present and only the typical peaks of metallic copper at 932 and 952 eV appears. Also for rGO a single peak appears at 284 eV attributed to sp²C while the C-O band at 286 eV decrease significantly.

Typically, in Cu NWs/rGO layer according to the invention, ionization energy (IE) of the hybrid film resulted 4.90 ± 0.02 eV.

In one embodiment, the invention relates to a Cu NWs/rGO films on PET substrate.

Advantageously, the material according to the present invention, comprising a substrate and a layer comprising copper nanowires and reduced graphene oxide, forms or is used as a transparent electrode.

In one embodiment, the invention relates to Cu NWs/GO films on PET substrate acting as transparent electrode.

Advantageously, the material according to the present invention, comprising a flexible substrate and a layer

comprising copper nanowires and reduced graphene oxide, forms or is used as a flexible electrode.

Advantageously, electrodes according to the present invention can be used for (opto)electronic applications.

In one embodiment, the material according to the present invention, comprising a substrate and a layer comprising copper nanowires and reduced graphene oxide, is used in electronic devices or in touch screens, flat displays, solar cells or organic light-emitting diodes.

Advantageously, the material according to the present invention, comprising a substrate and a layer comprising copper nanowires and reduced graphene oxide, forms or is used as transparent electrode suitable for a flexible electronic device.

In the present invention the terms process and method are equivalent and each can replace the other.

The term "a" designates "one and more" or "at least one".

Other aims, characteristics and advantages of the invention will appear clearly to the person skilled in the art upon reading the explanatory description which makes reference to the Examples which are given simply as an illustration and which in no way limit the scope of the invention.

The Examples make up an integral part of the present invention, and any characteristic which appears novel with respect to any prior state of the art from the description taken in its entirety, including the Examples, makes up an integral part of the invention in its function and in its generality.

Thus, every example has a general scope.

Furthermore, in the Examples, all percentages are given by weight, unless indicated otherwise, temperature is expressed in degrees Celsius unless indicated otherwise, and the pressure is atmospheric pressure, unless indicated otherwise.

In the figures:
Figure 1 is a schematic representation of the preparation of the electrodes.

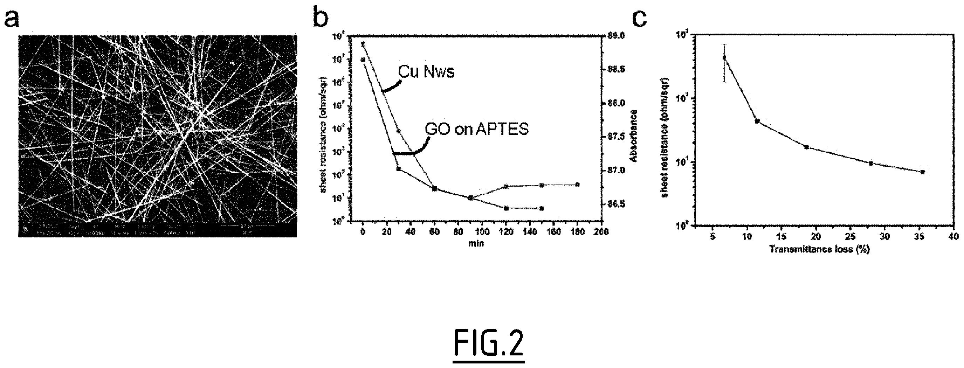

Figure 2 represents: a) SEM of Cu Nws on Au coated glass substrate. b) Influence of aqueous NaBH₄ time treatment on electrode sheet resistance of Cu Nws and on the absorption of GO (λ_{abs} = 550 nm) on APTES treated glass substrate. c) Effect of the amount of Cu NWs in terms of transmittance vs electrode sheet resistance (λ_{abs} = 550 nm) after 2.5 hours treatment with NaBH₄.

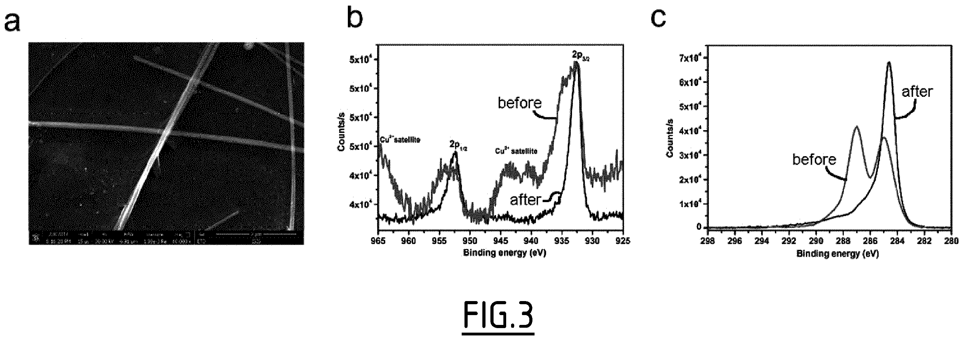

Figure 3 represents: a) SEM of Cu NWs/rGO after reduction on Au coated glass. XPS analysis of Cu (b) and C (c) of the substrate before ("before" line) and after ("after" lines) reduction with NaBH₄.
Figure 4 represents measurements of the ionization energy for copper nanowires and rGO by photoemission spectroscopy in air (PESA), (■, squares) Cu Nws. (•, circles) rGO, (A, triangles) Cu Nws/rGO hybrid.

### Examples

### Example 1 - Synthesis of Cu NWs

Cu NWs dispersion was prepared according to published procedure with some modification⁵ and involved a Cu(II) salt, a surfactant, a reducing agent and an additive, using water as solvent. In particular in a glass bottle CuCl₂·2H₂O (76 mg, 0.446 mmol) was dissolved in 20 mL of deionized water, followed by the addition of Octadecylamine (360 mg, 1.34 mmol). The suspension was sonicated until a light blue emulsion was obtained. Then glucose (100 mg, 0.55 mmol) and glycine (120 mg, 1.6 mmol) were added. The emulsion was heated at 50 °C for 10 min. Then the closed bottle was placed in an oven at 103 °C for 7 hours. The resulting Cu Nws were centrifuged with ethanol/water mixture 1/1 (30 mL, 8000 rpm, 8 min), and pure ethanol. Finally the resulting pure Cu Nws were dispersed into ethanol 35 mL. The dispersion was approximatively 0.4 mg/mL.

### Example 2 - Preparation of electrodes according to the invention

PET substrates (2.5 cm x 2.5 cm) were cleaned with ethanol and dried under a stream of air. In the case of glass substrates an additional cleaning with Uv-ozone was performed (10 min). In order to improve the affinity of the glass substrate with GO (3-Aminopropyl)triethoxysilane (APTES) was sprayed on top (30 uL in 13 mL ethanol). The spray coating was performed using a commercial airbrush. Subsequently the ethanolic dispersion of Cu Nws was sprayed onto the surface. Then commercial graphene oxide dispersion in water (4mg/ mL, Graphenea) was diluted with ethanol 60 times and sonicated 30 min. The clear yellow dispersion was then sprayed onto the top. Finally the substrate was dipped into a fresh aqueous solution of NaBH₄ (0.1% w/w) for 2.5 hours. Then the substrates were washed with water and ethanol and dried with nitrogen.

The substrate employed for SEM, UPS and XPS were glass coated with 2 nm of Cr followed 38 nm of gold by standard evaporation technique.

### Example 3 - PESA measurements

The ionization energy of the copper nanowires with reduced graphene oxide (produced according to example 2) deposited on 230 nm SiO₂/Siⁿ⁺⁺ substrates have been measured by photoemission spectroscopy in air (PESA), with an AC-2 Photoelectron Spectrometer (from Riken-Keiki Co.). The UV light intensity used for the measurements was 40 nW with a counting time of 10 seconds per point.

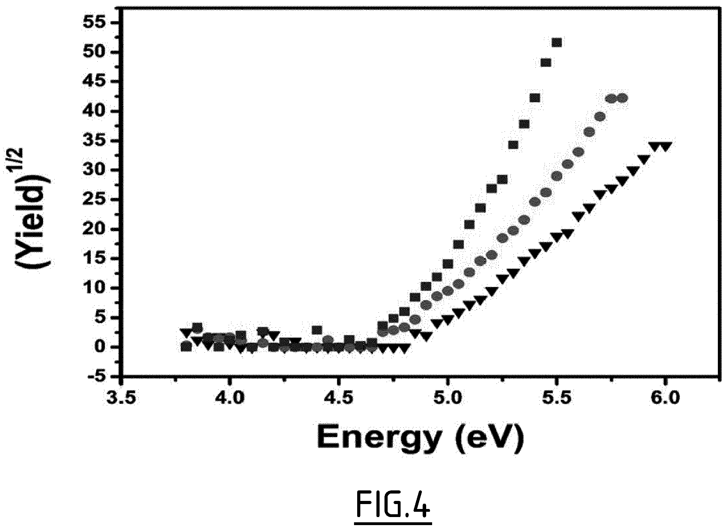

Figure 4 illustrates the ionization energy for copper nanowires and rGO by photoemission spectroscopy in air (PESA).

**Table 1. Thickness of the samples used for the PESA measurements estimated through an Alpha step IQ surface profiler.**

| | **rGO** | **CuNW** | **CuNW+rGO** |
|---|---|---|---|
| **Thickness (nm)** | 60 ± 10 | 250 ± 150 | 350 ± 100 |

## Claims

1. A process for preparing a material comprising a substrate and a coating layer comprising copper nanowires and reduced graphene oxide, said process comprising:
- placing at least one copper nanowires layer on a substrate, placing at least one graphene oxide layer in contact with a copper nanowire layer;
- simultaneously chemically reducing graphene oxide (GO) and copper nanowires (Cu NWs), thereby forming onto the substrate a coating layer comprising copper nanowires and reduced graphene oxide (rGO), thereby
- providing a material comprising a substrate and a coating layer comprising copper nanowires and reduced graphene oxide.

2. The process according to claim 1, wherein said process comprises the deposition of a suspension of Cu NWs on said substrate.

3. The process according to claim 1 or 2, wherein said process comprises a spray deposition of a suspension of GO flakes on said Cu NWs.

4. The process according to any one of claims 2 or 3, wherein said suspension is an ethanolic suspension.

5. The process according to any one of claims 1 to 4, wherein said process comprises simultaneously chemically reducing Cu NWs and GO in the presence of NaBH₄ as reducing agent.

6. The process according to any one of claims 1 to 5, wherein said process comprises simultaneously chemically reducing Cu NWs and GO and the simultaneous chemically reduction performed in water.

7. The process according to any one of claims 1 to 6, wherein said simultaneous chemically reduction is performed at a temperature ranging from 15 to 30°C, preferably at room temperature (20-25°C).

8. A material comprising a substrate comprising or consisting of a material having a glass transition temperature lower than 180°C; and a layer comprising copper nanowires and reduced graphene oxide, said layer coating at least one surface of said substrate.

9. A material obtained according to a process as defined in any one of claims 1 to 7.

10. A transparent electrodes comprising a material as defined in any one of claims 8 to 9.
